# DEMANDE DE BREVET EUROPEEN

(11) **EP 0 763 799 A1**
(43) Date de publication de la demande: **19.03.1997**
(21) Numéro de dépôt: 96401954.1
(22) Date de dépôt: 12.09.1996
(51) Int. Cl.: G06K 19/077

(54) **Collecteur d'onde en forme de bobinage imprimé pour objet portatif électronique tel que carte ou badge sans contact**

(30) Priorité: 15.09.1995 FR 9510781
(71) Demandeur: INNOVATRON INDUSTRIES, Société Anonyme, F-75002 Paris (FR)
(72) Inventeur: Brice, Patrice, 94300 Vincennes (FR)
(74) Mandataire: Dupuis-Latour, Dominique

(57) **Abrégé**

Cet objet comprend un circuit réalisé sur un circuit imprimé double face, avec un bobinage gravé sur le circuit imprimé, ce bobinage comprenant une pluralité de spires alternées gravées sur chacune des faces de la carte, chacune de ces spires étant une spire ouverte reliée à son extrémité, par un via traversant la carte, à l'extrémité voisine homologue de la spire suivante disposée sur la face opposée de la carte, les spires successives étant ainsi reliées en série de manière alternée et concentrique par une série de vias.

Selon l'invention, sur une première face les régions terminales des spires en vis-à-vis sont prolongées au-delà de la ligne médiane des extrémités de spires de manière à imbriquer alternativement ces régions terminales et sur la face opposée l'étendue des spires (S1, S3, S5, S7) est limitée de manière à ménager une zone libre (25) radiale, les vias de traversée (T1 - T8) étant disposés à l'extérieur de cette zone libre et le long de celle-ci, la carte comprenant en outre au moins une piste conductrice gravée (26) reliant un point situé à l'intérieur du bobinage à un point situé à l'extérieur du bobinage et passant à l'intérieur de la zone libre et le long de celle-ci.

## Description

L'invention concerne un objet portatif du type "carte sans contact" ou "badge sans contact", c'est-à-dire un objet portatif susceptible d'échanger des informations avec un lecteur externe en approchant l'objet de celui-ci de manière à permettre un couplage électromagnétique, non galvanique. L'échange d'informations (lecture et, éventuellement, écriture d'une mémoire de données incorporée à l'objet) se fait alors par voie radioélectrique ou en faisant varier un champ magnétique produit par une bobine d'induction.

Comme exemple de tels objets portatifs, on trouve les badges utilisés pour le télépéage, notamment le télépéage de transports urbains tels que métro ou autobus. Cette application n'est cependant qu'un exemple, et ces objets portatifs peuvent être utilisés dans de nombreuses autres techniques, telles que par exemple le contrôle d'accès physique à des locaux protégés.

Cette technique est en elle-même bien connue, et on pourra par exemple se référer au FR-A-2 640 830, qui décrit un exemple de structure d'objet portatif convenant à une telle application, et au EP-A-0 565 469, qui décrit la manière dont l'échange de données est opéré sans contact entre un objet portatif et un lecteur.

Un tel badge comporte un collecteur d'ondes incorporé sensible à la composante magnétique du champ électromagnétique, réalisé sous forme d'un bobinage intégré, le plus souvent un bobinage directement gravé sur la carte de circuit imprimé portant les divers composants du circuit électronique.

L'invention s'applique particulièrement au cas où ce bobinage est réalisé sous forme d'une série de spires gravées sur l'une et l'autre des faces de la carte (ou sur deux couches successives dans le cas, plus général, d'un circuit imprimé multicouches). Le FR-A-2 640 830 précité comporte ainsi quatre spires sur le recto de la carte et quatre spires sur le verso, respectivement en vis-à-vis de part et d'autre de la carte.

La présence des spires du bobinage sur l'une et l'autre face de la carte a cependant pour inconvénient de créer un contour fermé empêchant toute liaison par une piste imprimée entre un ou plusieurs points situés à l'intérieur de ce contour et des points homologues situés à l'extérieur.

Cette liaison (ou chacune de ces liaisons) est alors réalisée par un élément conducteur rapporté ou "strap". On peut ainsi prévoir le report d'un "strap" isolé comportant à ses extrémités une zone étamée pour permettre son montage, le circuit imprimé comportant alors des plages pour accueillir ces extrémités ; on peut également utiliser un "strap" non isolé, par exemple un fil étamé, le circuit imprimé étant alors pourvu, outre les plages d'accueil des extrémités, d'un vernis permettant d'isoler la zone centrale du "strap" d'avec les régions conductrices du circuit imprimé, notamment les conducteurs formant les spires du bobinage.

Un des buts de la présente invention est de pouvoir réaliser une telle liaison entre des points intérieurs et des points extérieurs au bobinage sans report d'aucun élément, ceci grâce à une topologie particulière des spires qui permette le passage de pistes conductrices directement gravées sur l'une des faces de la carte imprimée, avec les avantages corrélatifs en ce qui concerne la simplification du processus industriel et la réduction correspondante du coût unitaire du produit.

En effet, on peut ainsi supprimer les "straps" et s'affranchir de tout problème d'isolation de ceux-ci par rapport au circuit imprimé. De plus, l'invention permet de réaliser une pluralité de liaisons pour un coût identique, par exemple pour le passage de fils d'alimentation, la connexion à un point milieu du bobinage, etc., alors que la multiplication du nombre des "straps" impliquerait une augmentation corrélative du coût de production.

La présente invention vise, ainsi, un objet portatif du type précité, c'est-à-dire comprenant un circuit électronique réalisé sur une carte de circuit imprimé double face, avec des moyens d'émission/réception sans contact de données échangées avec un terminal distant, dans lequel les moyens d'émission/réception comprennent un collecteur d'onde en forme de bobinage gravé sur la carte de circuit imprimé, ce bobinage comprenant une pluralité de spires alternées gravées sur chacune des faces de la carte, chacune de ces spires étant une spire ouverte reliée à son extrémité, par un via traversant la carte, à l'extrémité voisine homologue de la spire suivante disposée sur la face opposée de la carte, les spires successives étant ainsi reliées en série de manière alternée et concentrique par une série de vias.

Selon l'invention, sur une première face de la carte l'étendue en direction curviligne des régions terminales des spires en vis-à-vis est prolongée au-delà de la ligne médiane des extrémités de spires de manière à imbriquer alternativement ces régions terminales et, sur la face opposée de la carte, l'étendue en direction curviligne des régions terminales des spires en vis-à-vis est limitée de manière à ménager une zone libre s'étendant approximativement radialement, les vias de traversée étant disposés à l'extérieur de cette zone libre et le long de celle-ci, la carte comprenant en outre au moins une piste conductrice gravée reliant un point situé à l'intérieur du bobinage à un point situé à l'extérieur du bobinage et passant à l'intérieur de la zone libre et le long de celle-ci.

Selon diverses caractéristiques avantageuses :
- les spires ont sensiblement une forme de carré ou de rectangle, et les régions terminales des spires s'étendent au voisinage d'un des sommets de ce carré ou de ce rectangle, la ligne médiane des extrémités des spires s'étendant de préférence sensiblement parallèlement à l'une des diagonales du carré ou du rectangle ;
- ledit point situé à l'intérieur du bobinage est relié à l'extrémité d'une spire interne du bobinage, ou ledit point situé à l'extérieur du bobinage est relié à l'extrémité d'une spire externe du bobinage, notamment pour la liaison à une borne du bobinage ;
- ledit point situé à l'intérieur du bobinage est relié à une borne d'alimentation et ledit point situé à l'extérieur du bobinage est relié à une borne du circuit électronique, ou ledit point situé à l'extérieur du bobinage est relié à une borne d'alimentation et ledit point situé à l'intérieur du bobinage est relié à une borne du circuit électronique ;
- un autre point situé à l'extérieur du bobinage est relié à un via intermédiaire par une autre piste conductrice gravée passant à l'intérieur de la zone libre et le long de celle-ci, notamment pour la liaison à une prise intermédiaire du bobinage.

D'autres caractéristiques et avantages de l'invention apparaîtront à la lecture de la description détaillée ci-dessous, faite en référence aux dessins annexés.

La figure 1 est une vue de face d'un exemple de badge sans contact auquel peuvent être appliqués les enseignements de l'invention.

La figure 2 est une vue de face d'une carte de circuit à l'intérieur d'un tel objet, montrant les différentes pistes et plages conductrices, notamment les spires d'un bobinage imprimé réalisé selon l'art antérieur.

Les figures 3 et 4 sont des vues de la configuration du bobinage selon les enseignements de l'invention, formé respectivement sur une première et une seconde couche de circuit imprimé (correspondant au recto et au verso de la carte).

La figure 5 est une vue agrandie de la partie supérieure droite de la figure 3, montrant plus précisément la géométrie particulière en cet endroit.

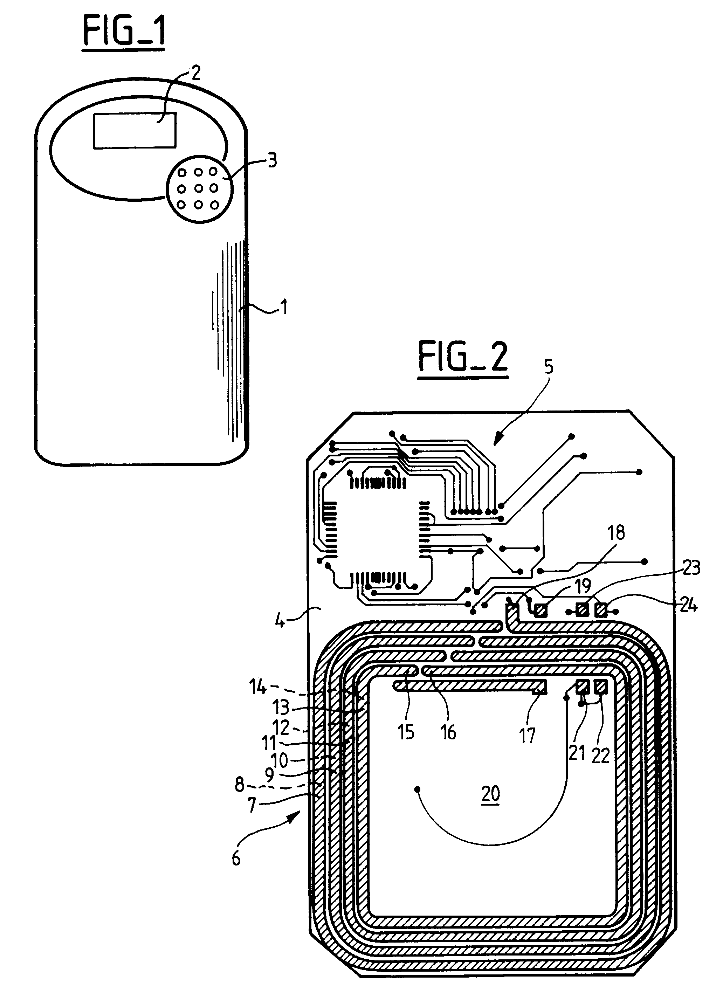

Sur la figure 1, on a représenté un objet portatif du type "badge" tel qu'utilisé par exemple pour le télépéage des transports en commun. Extérieurement, ce badge 1 comporte simplement un afficheur 2 et un bouton-poussoir 3.

Le badge contient à l'intérieur un circuit électronique, réalisé sur une carte de circuit imprimé double face, référencée 4 sur la figure 2, sur laquelle on n'a représenté que les pistes conductrices, sans les composants qui sont par exemples montés sur cette carte en technologie CMS et éventuellement en technologie de pastillage (technologie dite également COB, *Chip On Board).*

La carte 4 comporte, outre les diverses pistes 5 d'interconnexion des composants et de la puce, un bobinage imprimé, référencé 6.

Dans la configuration de l'art antérieur, illustrée figure 6, (et qui correspond à la structure décrite dans le FR-A-2 640 830 précité, auquel on pourra se référer pour de plus amples détails), le bobinage est constitué d'une pluralité de spires, par exemple deux séries de spires sur chaque face, la face visible figure 2 montrant les spires 7, 9, 11 et 13 et d'autres spires 8, 10, 12 et 14 étant prévues en vis-à-vis de l'autre côté de la carte.

Chacune de ces spires a par exemple une forme sensiblement carrée (ou rectangulaire) et comporte deux extrémités 15, 16 qui constituent le point de départ d'une traversée ou "via" lui permettant de communiquer avec l'autre côté de la carte pour se prolonger sur ce dernier par une spire ayant sensiblement les mêmes dimensions et dont l'extrémité sera située à l'endroit d'un autre via lui permettant de traverser l'épaisseur de la carte et se prolonger par la spire 9, et ainsi de suite.

La spire située la plus à l'intérieur se termine sur une plage de contact 17, et celle située le plus à l'extérieur par une plage de contact 18 qui, sur l'exemple représenté, est directement reliée aux pistes conductrices 5 assurant la connexion aux divers éléments du circuit. La liaison de ce circuit avec la plage 17 est réalisée par l'intermédiaire d'un "strap" placé entre la plage 17 et une plage 19 et venant chevaucher l'ensemble des spires 7, 9, 11 et 13.

L'espace central 20 défini à l'intérieur du bobinage 6 peut être utilisé pour placer d'autres composants, tout particulièrement une batterie d'alimentation dont les deux pôles seront reliés à des plages 21 et 22 reliées par d'autres "straps" à des plages 23 et 24 situées en vis-à-vis et permettant d'alimenter les divers composants du circuit.

On notera que la configuration illustrée, avec le circuit à l'extérieur du bobinage et l'alimentation à l'intérieur, peut être inversée, c'est-à-dire en prévoyant les circuits 5 à l'intérieur et l'alimentation à l'extérieur du bobinage, mais le problème de la traversée du bobinage par des "straps" de liaison se posera de façon identique.

L'invention propose, par une topologie particulière des spires du bobinage 6, d'éviter le recours à un ou plusieurs "straps", en permettant l'établissement d'une ou plusieurs liaisons entre l'intérieur et l'extérieur du bobinage exclusivement par des conducteurs gravés sur la carte imprimée.

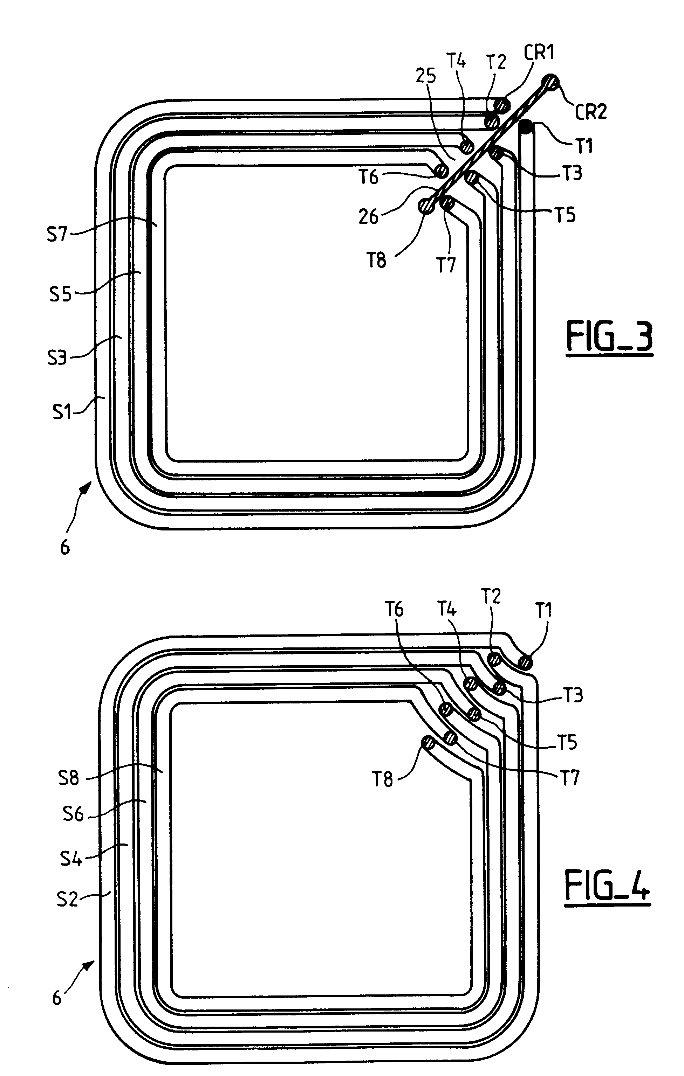

Sur les figures 3 et 4 on a représenté les deux couches de circuit illustrant cette topologie, la figure 3 correspondant par exemple au recto de la carte et la figure 4 au verso de celle-ci (la représentation a été faite en couches superposables, le masque de gravure pour l'une des couches devant être inversé par rapport à ce qui est illustré).

Dans l'exemple illustré, l'antenne est constituée de huit spires référencées S1 à S8, à savoir quatre spires S1, S3, S5 et S7 sur une face du circuit et les quatre autres S2, S4, S6 et S8 sur l'autre face. Le bobinage est réalisé en reliant en série alternativement une face puis l'autre à chaque spire.

Essentiellement, on prévoit sur l'une des faces (celle illustrée figure 3) de ménager entre les extrémités de chacune des spires un espace libre 25 orienté radialement de manière à définir un "couloir" radial permettant le passage d'un ou plusieurs conducteurs 26. Dans l'exemple illustré, le conducteur 26 permet de relier l'extrémité T8 de la spire la plus intérieure S8, c'est-à-dire la dernière spire du bobinage, à un élément de circuit situé à l'extérieur du bobinage 6 (liaison qui était assurée par le "strap" monté entre les plages 17 et 19 dans l'exemple de la figure 2 selon l'art antérieur). On comprendra que l'on peut aisément faire passer dans ce "couloir" d'autres conducteurs, par exemple des lignes d'alimentation ou des conducteurs de liaison à une prise intermédiaire ou un point milieu du bobinage, dès lors que la largeur de ce couloir est suffisante pour respecter les distances d'isolement requises.

Le bobinage commence à la première borne CR1 par la spire S1, qui se termine à la traversée T1 (figure 3) où un via la fait communiquer à l'endroit de cette traversée avec le début de la deuxième spire S2 (figure 4), qui se termine quant à elle à la traversée T2 et se prolonge de l'autre côté du circuit par la spire S3 (figure 3), et ainsi de suite. La dernière spire S8 aboutit à la traversée T8 qui est ramenée, par le conducteur 26 mentionné plus haut, jusqu'à un point CR2, à l'extérieur de la boucle, constituant la seconde borne du bobinage 6.

On remarquera que si, sur la face illustrée figure 3, les extrémités T1, T3, T5 et T7, d'une part et CR1, T2, T4 et T6 d'autre part sont disposées selon deux lignes respectives à distance l'une de l'autre (pour définir l'espace libre du couloir 25), sur l'autre face illustrée figure 4, la configuration inverse prévaut, c'est-à-dire qu'il y a imbrication des extrémités de spires respectives, l'extrémité de piste aboutissant à la traversée T2 étant imbriquée entre les extrémités de pistes aboutissant aux traversées T1 et T3, et ainsi de suite.

On notera que la configuration de l'invention permet de prévoir aisément une prise intermédiaire sur le bobinage en prenant la connexion dans la zone libre à l'endroit d'une traversée (par exemple T4, CR1 étant alors le début du bobinage, T4 le point milieu et T8/CR2 la fin du bobinage) ; il y a alors deux conducteurs dans l'espace libre du couloir 25, à savoir le conducteur 26 reliant T8 à CR2 et un conducteur supplémentaire reliant T4 à un autre point à l'extérieur.

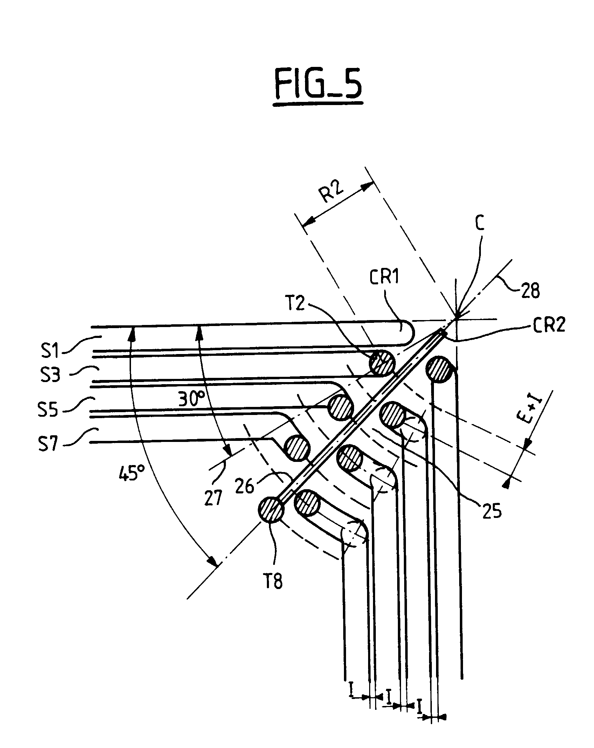

La figure 5 illustre plus en détail la manière dont on détermine les positions des diverses traversées à la conception du masque de gravure.

On dessine tout d'abord les spires S1, S3, S5 et S7 de manière concentrique, en respectant l'isolement I entre spires adjacentes. Dans l'exemple illustré, on donne aux spires une forme approximativement carrée, avec des angles arrondis, et on fait se terminer les extrémités des spires approximativement le long d'une diagonale de ce carré (d'autres configurations étant bien entendu possibles).

On dessine ensuite les spires S2, S4, S6 et S8 sur la seconde couche, en vis-à-vis des spires S1, S3, S5 et S7, respectivement.

On dessine ensuite la liaison radiale 26, de préférence le long d'une des diagonales du carré, en respectant un isolement I entre le conducteur radial et les spires, correspondant donc à une largeur E + 2.I pour la zone libre radiale 25.

On dessine ensuite la traversée T2, le plus près possible du conducteur radial 26 compte tenu des distances d'isolement.

On trace ensuite une droite 27, inclinée de 30° par rapport au côté du carré et passant par le centre de la traversée T2, définissant ainsi un point C à l'intersection de cette droite 27 avec la direction 28 du conducteur radial.

On trace ensuite un cercle de centre C passant par la traversée T2, ce qui donne un rayon R2. Les distances entre le centre C et les traversées T1 à T8 seront obtenues à partir de R2 en ajoutant ou en retranchant à cette valeur un certain nombre de fois E + I, donnant des rayons correspondant R1 à R8. Les traversées T1 à T8 seront alors placées le plus près possible du conducteur radial 26, et il suffira alors d'effectuer le raccordement par des arcs de cercle entre la traversée T1 et les spires S1 et S2, la traversée T2 et les spires S2 et S3, et ainsi de suite jusqu'à la traversée T7 et les spires S7 et S8.

Le conducteur radial 26 peut alors être raccordé à la spire intérieure S8 par l'intermédiaire de la traversée T8.

Le bobinage ainsi constitué a ses extrémités CR1 et CR2 situées à l'extérieur du bobinage, et celles-ci peuvent donc être directement reliées aux divers circuits du badge sans liaison rapportée.

En variante, le conducteur radial aurait pu être raccordé à la spire extérieure S1, et le bobinage aurait alors eu ses deux extrémités CR1 et CR2 à l'intérieur du bobinage, solution qui convient aux cas où les circuits se trouvent non plus à l'extérieur mais à l'intérieur de ce bobinage.

## Revendications

1. Un objet portatif (1) tel qu'une carte ou un badge, comprenant un circuit électronique réalisé sur une carte de circuit imprimé double face (4), avec des moyens d'émission/réception sans contact de données échangées avec un terminal distant, dans lequel les moyens d'émission/ réception comprennent un collecteur d'onde en forme de bobinage (6) gravé sur la carte de circuit imprimé, ce bobinage comprenant une pluralité de spires alternées (S1, S3, S5, S7 ; S2, S4, S6, S8) gravées sur chacune des faces de la carte, chacune de ces spires étant une spire ouverte reliée à son extrémité, par un via (T1 - T8) traversant la carte, à l'extrémité voisine homologue de la spire suivante disposée sur la face opposée de la carte, les spires successives étant ainsi reliées en série de manière alternée et concentrique par une série de vias,
caractérisé en ce que, sur une première face de la carte, l'étendue en direction curviligne des régions terminales des spires en vis-à-vis est prolongée au-delà de la ligne médiane des extrémités de spires de manière à imbriquer alternativement ces régions terminales et, sur la face opposée de la carte, l'étendue en direction curviligne des régions terminales des spires en vis-à-vis est limitée de manière à ménager une zone libre (25) s'étendant approximativement radialement, les vias de traversée étant disposés à l'extérieur de cette zone libre et le long de celle-ci, la carte comprenant en outre au moins une piste conductrice gravée (26) reliant un point situé à l'intérieur du bobinage à un point situé à l'extérieur du bobinage et passant à l'intérieur de la zone libre et le long de celle-ci.

2. L'objet portatif de la revendication 1, dans lequel les spires ont sensiblement une forme de carré ou de rectangle, et les régions terminales des spires s'étendent au voisinage de l'un des sommets de ce carré ou de ce rectangle.

3. L'objet portatif de la revendication 2, dans lequel la ligne médiane des extrémités des spires s'étend sensiblement parallèlement à l'une des diagonales du carré ou du rectangle.

4. L'objet portatif de la revendication 1, dans lequel ledit point situé à l'intérieur du bobinage est relié à l'extrémité d'une spire interne du bobinage, ou ledit point situé à l'extérieur du bobinage est relié à l'extrémité d'une spire externe du bobinage, notamment pour la liaison à une borne du bobinage.

5. L'objet portatif de la revendication 1, dans lequel ledit point situé à l'intérieur du bobinage est relié à une borne d'alimentation et ledit point situé à l'extérieur du bobinage est relié à une borne du circuit électronique, ou ledit point situé à l'extérieur du bobinage est relié à une borne d'alimentation et ledit point situé à l'intérieur du bobinage est relié à une borne du circuit électronique.

6. L'objet portatif de la revendication 1, dans lequel un autre point situé à l'extérieur du bobinage est relié à un via intermédiaire (T2-T7) par une autre piste conductrice gravée passant à l'intérieur de la zone libre et le long de celle-ci, notamment pour la liaison à une prise intermédiaire du bobinage.
